# EUROPEAN PATENT APPLICATION

(11) **EP 4 481 496 A1**
(43) Date of publication of application: **25.12.2024**
(21) Application number: 22926795.0
(22) Date of filing: 09.11.2022
(51) Int. Cl.: G03F 7/20

(54) **PHOTOETCHING MACHINE WITH OPTICAL FIBER ARRAYS**

(30) Priority: 18.02.2022 CN 202210151934
(71) Applicant: Westlake University, Hangzhou, Zhejiang 310024 (CN)
(72) Inventor: LI, Xijun, Hangzhou, Zhejiang 310024 (CN); SHAO, Luqing, Hangzhou, Zhejiang 310024 (CN)
(74) Representative: Petraz, Gilberto Luigi
(86) International application number: PCT/CN2022/130785
(87) International publication number: WO 2023/155491

(57) **Abstract**

A photoetching machine with optical fiber arrays, comprising a control device (1), an optical fiber transmission device (6), a light focusing array (7) and an electric drive workpiece table (8), and further comprising a photoetching light source (2a), an de-excitation light source (2b), a first-stage light splitting array (3), an electro-optical modulation array (4) and a second-stage light splitting array (5); the control device (1) is connected to the electro-optical modulation array (4) and the electric drive workpiece table (8); the control device (1) is used for controlling, on the basis of a design layout, the electro-optical modulation array (4) to modulate laser emitted by a laser light source and controlling the electric drive workpiece table (8) to move. A plurality of optical lenses or lens groups are prevented from being used, thereby realizing simpler optical paths, and greatly reducing the manufacturing and maintenance cost; a plurality of optical fibers are used to form an optical fiber bundle, and multi-beam parallel exposure is carried out, so that the photoetching efficiency can be improved; an electro-optical modulation array is used to implement on and off of optical energy of laser for photoetching and to achieve a high-speed patterning function of photoetching by combining movement of the electric drive workpiece table; and de-excitation light and photoetching light are combined to achieve super-resolution photoetching of an optical diffraction limit.

## Description

### Technical field

The present disclosure relates to a field of manufacturing chips or integrated circuits, in particular to a photoetching machine with optical fiber arrays.

### Background

The photoetching machine uses photons of violet light or ultraviolet light to irradiate the photoresist (photo-sensitive resist) coated on the surface of a wafer or sample, so that the molecular size of the photoresist changes, thereby its solubility in a specific solvent produces a certain contrast. The solvent is used to develop the selectively exposed photoresist coated on the surface of the wafer/sample to form a pattern. Photoetching machine is the core equipment of a chip production line, and the minimum line width that can be obtained after photoresist is exposed is the most important index of a photoetching machine and represents the advanced level of the chip production line. For a state-of-the-art chip production line, one or more photoetching machines with different processing accuracy are usually equipped in its transistor manufacturing process (front end of line) and inter-transistor interconnection process (back end of line) depending on the transistor integration level and chip wiring requirement.

The photoetching machines can be divided into two types according to the manner of forming a pattern on the photoresist. The first type is that the light spots with uniform intensity distribution pass through a photoetching mask with transparent and opaque region patterns to form an image having high fidelity with mask pattern on the photoresist. This category of photoetching machine is widely used in semiconductor production line. The second type of photoetching machine uses a focused light beam to scan the area that needs to be exposed on the photo-sensitive resist, or uses a spatial light modulator to modulate light intensity of a uniform light spots distribution region to form a pattern of spatially contrasting pattern, and then realizes exposure on the photosensitive adhesive. This type of photoetching machine is called maskless photoetching machine because it does not need a photoetching mask, the former being also called laser direct writing and the latter being also called LDI. The two types of photoetching machine are designed with free-space optical structure, that is, when during the light emitted from the light source reaches the photoresist surface, the light is exposed in air or vacuum. In addition, limited by the principle of light diffraction, the resolution of photoetching reaches about 1/4 of the exposure wavelength by combining various technologies to improve the resolution.

### Summary of the invention

In view of this, the embodiments of the present disclosure propose a photoetching machine with optical fiber arrays to address the problems in the prior art.

In an aspect, the present disclosure provides a photoetching machine with optical fiber arrays, comprising a control device, an optical fiber transmission device, an light focusing array and an electric drive workpiece table, and further comprising a photoetching light source, a de-excitation light source, a first-stage light splitting array, an electro-optical modulation array and a second-stage light splitting array, wherein the photoetching light source and the de-excitation light source respectively emit an exposure Gaussian beam and a de-excitation Gaussian beam with different wavelengths, the control device is connected to the electro-optical modulation array and the electric drive workpiece table, and is used for controlling the electro-optical modulation array to modulate a laser emitted by the laser light source and controlling the electric drive workpiece table to move based on a design layout.

In some embodiments, the control device is used for decomposing the design layout into multiple layers of pattern depending on the processing technology, generating photoetching data based on each layer of pattern, and generating electro-optical modulation signal for the electro-optical modulator and workpiece table control signal for the electric drive workpiece table based on the photoetching data.

In some embodiments, the first-stage light splitting array is provided between the laser light source and the electro-optic modulation array, and comprises a first light splitter and n first-stage light channels, and the first-stage light splitting array is used for uniformly distributing the laser emitted by the laser light source into the n first-stage light channels through the first light splitter, and the n first-stage light channels output photoetching light in a form of an optical fiber coupler.

In some embodiments, the electro-optical modulation array comprises n modulation channels forming an array, the modulation channels are correspondingly coupled with the first-stage light channels, a corresponding modulator is provided in each modulation channel, and each modulator corresponds to and controls and modulates the photoetching light output from the corresponding first-stage light channel.

In some embodiments, the second-stage light splitting array is provided between the electro-optical modulation array and the optical fiber transmission device, and comprises a second light splitter and c second-stage light channels, wherein the second-stage light splitting array uniformly distributes the photoetching light pulses output from each of the n modulation channels of the electro-optical modulation array into the c second-stage light channels, and the c second-stage light channels output photoetching light pulses in a form of an optical fiber coupler.

In some embodiments, the optical fiber transmission device is an optical fiber bundle for photoetching, which is capable of at least receiving an exposure Gaussian beam and an de-excitation Gaussian beam with different wavelengths, and the optical fiber bundle for photoetching comprises c sub-optical fiber bundles, each of which comprises n optical fibers, each of which comprises an optical fiber core for transmitting light beams, an optical fiber cladding is provided around the outer side of the optical fiber core, a spiral phase structure is provided at an incident end of the optical fiber core, and a lens structure is provided at the outer side of an exit end of the optical fiber core.

In some embodiments, the exposure Gaussian beam is ultraviolet light, and the de-excitation Gaussian beam is a laser beam, wherein during exposure, the de-excitation Gaussian beam is converted into a doughnut-shaped structured light beam, and the exposure Gaussian beam is located in an inner circle with the weakest light intensity of the doughnut-shaped structured light beam.

In some embodiments, the light focusing array is a fiber lens that is capable of being coupled with the optical fiber transmission device.

In some embodiments, the electric drive workpiece table comprises a plurality of driving devices to realize the positioning and control of an exposure position on the photoetching material in three axial directions XYZ, wherein the X-axis and the Y-axis are located in the focal plane in which the light focusing array focuses the optical signal, and the Z-axis is along the direction perpendicular to the focal plane.

According to the embodiments of the present disclosure, the laser light source and the light focusing array are connected by optical fibers, thus avoiding the difficulty of using a plurality of optical lenses or lens groups in design and production of the photoetching machine emitting lasers in free space, thus realizing simpler optical paths, and greatly reducing the manufacturing and maintenance costs; a plurality of optical fibers are used to form an optical fiber bundle, and multi-beam parallel exposure is carried out to improve photoetching efficiency; the electro-optical modulation array is used to switch the laser energy for photoetching, by combining with the movement of the electric drive workpiece table, to realize the high-speed patterning function of photoetching. The photoetching machine implemented in the present disclosure can also realize the super-resolution photoetching function because the Gaussian exposure beam is located in the inner circle with the weakest intensity of doughnut-shaped structured light.

### Brief Description of the Drawings

In order to more clearly explain the embodiments of the present disclosure or the technical solutions in the prior art, the accompanying drawings needed in the description of the embodiments or the prior art will be briefly introduced below. Obviously, the accompanying drawings in the following description are only some of the embodiments recorded in the present disclosure, and other accompanying drawings can be obtained according to these accompanying drawings for those skilled in the art without creative work.
FIG. 1 is a system schematic diagram of a photoetching machine with optical fiber arrays according to an embodiment of the present disclosure;
FIG. 2 is a schematic structural diagram of a first-stage optical splitting array in a photoetching machine with optical fiber arrays according to an embodiment of the present disclosure;
FIG. 3 is a schematic structural diagram of an electro-optical modulation array in a photoetching machine with optical fiber arrays according to an embodiment of the present disclosure;
FIG. 4 is a schematic structural diagram of a second-stage optical splitting array in a photoetching machine with optical fiber arrays according to an embodiment of the present disclosure;
FIG. 5 is a schematic structural diagram of an optical fiber bundle for photoetching in a photoetching machine with optical fiber arrays according to an embodiment of the present disclosure;
FIG. 6 is a schematic structural diagram of a light focusing array in a photoetching machine with optical fiber arrays according to an embodiment of the present disclosure;
FIG. 7 is a schematic block diagram of a control device in a photoetching machine with optical fiber arrays according to an embodiment of the present disclosure.

### Detailed Embodiments

In order to make the purposes, technical solutions and advantages of the embodiments of the present disclosure clearer, the technical solutions of the embodiments of the present disclosure will be clearly and completely described below with reference to the accompanying drawings of the embodiments of the present disclosure. Obviously, the described embodiments are a part of the embodiments, rather than the entire embodiments, of the present disclosure. Based on the described embodiments of the present disclosure, all other embodiments obtained by those skilled in the art without creative work fall into protection scope of the present disclosure.

Unless otherwise defined, technical terms or scientific terms used in the present disclosure shall have their ordinary meanings as understood by people with ordinary skills in the art to which the present disclosure belongs. The terms "first", "second" and the like used in the present disclosure do not indicate any order, quantity or importance, but are only used to distinguish different components. Similar words such as "comprise" or "contain" mean that the elements or objects appearing before the word cover the listed elements or objects appearing after the word and their equivalents, without excluding other elements or objects. Similar words such as "connection" or "connected" are not limited to physical or mechanical connection, and can comprise electrical connection, whether direct or indirect. "Up", "down", "left" and "right" are only used to indicate the relative positional relationship, and when the absolute position of the described object changes, the relative positional relationship may also change accordingly.

In order to keep the following description of the embodiments of the present disclosure clear and concise, the detailed description of known functions and known components is omitted from the present disclosure.

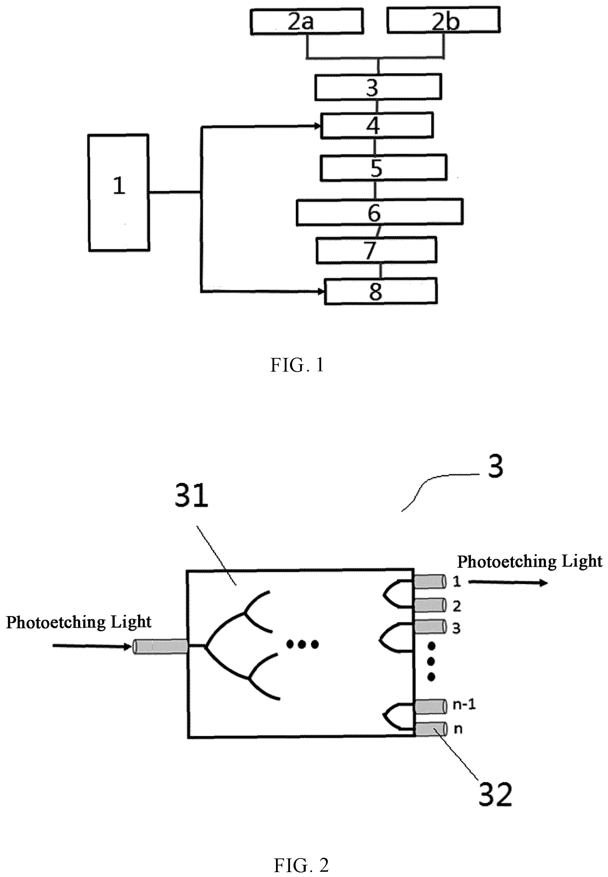

An embodiment of the present disclosure relates to a photoetching machine with optical fiber arrays, which is used to realize photoetching operation on photoetching materials, such as wafers, by means of exposure based on a preset design layout for photoetching. As shown in FIG. 1, FIG. 1 shows the schematic structural diagram of the photoetching machine with optical fiber arrays. The photoetching machine with optical fiber arrays comprises a control device 1, a photoetching light source 2a, a de-excitation light source 2b, a first-stage light splitting array 3, an electro-optical modulation array 4, a second-stage light splitting array 5, an optical fiber transmission device 6, an optical fiber focusing array 7 and an electric drive workpiece table 8. Here, the photoetching material is, for example, a wafer or other materials, and the wafer is provided on the electric drive workpiece table 8, and a photoresist is coated on the wafer by spin coating, glue spraying or other processes.

The photoetching light source 2a and the de-excitation light source 2b are respectively used for emitting an exposure Gaussian beam and a de-excitation Gaussian beam to the photoetching material located on the electric drive workpiece table 8, so as to realize super-resolution photoetching that breaks through the optical diffraction limit based on a pre-designed design layout; wherein, the control device 1 is connected to the electro-optical modulation array 4 and to the electric drive workpiece table 8, and controls the electro-optical modulation array 4 to modulate the exposure Gaussian beam to obtain matching exposure light pulses, and controls the electric drive workpiece table 8 to realize motion/movement respectively, based on the design layout. In this way, the modulated laser pulses can realize exposure of the photoetching material provided on the electric drive workpiece table 8 to complete the photoetching operation.

Specifically, as mentioned above, the control device 1 is used to, based on the design layout, control the electro-optical modulation array 4 to modulate the laser emitted by the exposure light source 2a and control the electric drive workpiece table 8 to move, respectively; wherein, the control device 1 can control through human-machine interface. Firstly, for example, the design layout of integrated circuit/chip that satisfies the target function is designed by a graphic software, or the design layout of integrated circuit that meets the requirement above is input based on a third-party designing software and the design layout is decomposed into multiple layers of exposure pattern depending on the processing technology, and exposure parameters are converted into photoetching data based on the exposure pattern of each layer and the type of the photoresist (such as positive photoresist or negative photoresist and the exposure sensitivity of photoresist). The photoetching data here refers to the data related to the implementation of the exposure for the photoetching material. Finally, based on the photoetching data, electro-optical modulation signal 11 for the electro-optical modulation array 4 and workpiece table control signal 12 for the electric drive workpiece table 8 are generated.

Further, the control device 1 modulates the laser emitted by the exposure light source 2a based on the electro-optical modulation signal 11, so as to obtain laser pulses with a width matching that required by the photoetching operation; the control device 1 controls the electric drive workpiece table 8 to move to a position of each exposure point through the workpiece table control signal 12, so as to realize the exposure operation. In this way, the control device 1 can synchronously control the electro-optical modulation array 4 and the electric drive workpiece table 8 with the electro-optical modulation signal 11 and the work table control signal 12, so as to perform the exposure operation on the photoresist on the photoetching material provided on the electric drive workpiece table 8, finally realizing a function of precise photoetching.

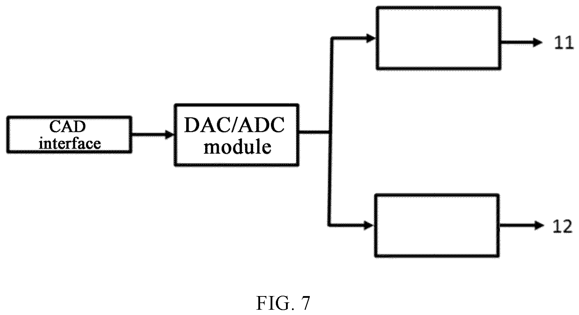

As shown in FIG. 7, the control device 1 acquires exposure-related data required by the photoetching material based on, for example, the design layout, and decomposes the exposure-related data into driving device control data and corresponding electro-optical modulation data through a DAC module or an ADC module, wherein the driving device control data at least comprises the position information on all exposure positions and non-exposure positions on the photoetching material, such as the wafer, that meets the requirements of the photoetching process, positioning information on the position of the wafer on the electric drive workpiece table 8 corresponding to each exposure position and non-exposure position, and the movement control data of the driving device; the electro-optical modulation data at least comprises voltage signal information and pulse width information corresponding to each exposure position and non-exposure position. Wherein, the electro-optical modulation signal 11 and the workpiece table control signal 12 are respectively generated based on the driving device control data and the corresponding electro-optical modulation data.

In particular, the function of optical fiber for photoetching is to convert the de-excitation laser into doughnut-shaped continuous structured light by a spiral phase plate at an incident end without affecting Gaussian photoetching light pulses; within the optical fiber, the doughnut-shaped de-excitation light and Gaussian photoetching light pulses propagate coaxially; the lens structure at an exit end of the optical fiber for photoetching focuses the Gaussian photoetching light pulses on a photoetching focal plane without affecting the doughnut shape of the continuous de-excitation light; in this way, in the photoetching focal plane, the exposure Gaussian beam is located in the inner circle with the weakest intensity of doughnut-shaped structured light, realizing super-resolution photoetching.

Each component of the photoetching machine with optical fiber arrays will be described in detail below.

The exposure Gaussian beam 11 emitted by the photoetching light source 2 is mainly used for exposure operation, and can be ordinary ultraviolet light, the wavelength of which can be in the range of, for example, 193 nm-405 nm, preferably in the range of 355 nm-405 nm. The de-excitation Gaussian beam 12 is a coherent light, such as a laser beam, and the wavelength range of the de-excitation Gaussian beam 12 emitted by the de-excitation light source 2b here can be in the range of 550 nm-1500 nm, although the types and wavelengths of the two Gaussian beams here are not limited to this. In one embodiment, the photoetching light source 2a for emitting a photoetching beam here may comprise a power supply and a laser. The laser light source here may adopt a variety of lasers, such as a solid-state laser, a semiconductor laser or a gas laser, or a laser array composed of a plurality of the same or different lasers, and the power for emitting a laser may be in the range of 1 mW to 1 kW. Here, it is preferred to adopt a laser capable of emitting laser through optical fiber output to facilitate coupling with the corresponding light channel in the device described later.

Further, if the photoetching light source 2a adopts a laser in a form of emitting into free space, the photoetching light source 2a may also comprise an optical fiber focusing array, and the light spot focused by the optical fiber focusing array may be directly coupled to the corresponding light channel behind.

As shown in FIG. 2, the first-stage light splitting array 3 is provided between the light source and the electro-optical modulation array 4, and comprises a first light splitter 31 and n first-stage light channels 32, wherein the first-stage light splitting array 3 is used for uniformly distributing the lasers emitted by the photoetching light source 2a and the de-excitation light source 2b into the n first-stage light channels 32 through the first light splitter 31. The n first-stage light channels 32 output photoetching light in the form of an optical fiber coupler, so that the intensities of photoetching light and de-excitation light can be uniformly distributed in the n optical fibers of the optical fiber transmission device 6. The first optical splitter 31 here can be realized by using separation optical elements, such as a spectroscope, a reflector or the like, or by using an integrated optical waveguide.

Further, the electro-optical modulation array 4 here comprises a high-frequency electrical signal generator. The high-frequency electrical signal generator receives the electro-optical modulation signal 11 transmitted by the control device 1, and the generated electric pulses can be amplified or not as required. However, finally, the optical phases of the two arms of the optical waveguide can be adjusted by electro-optical modulation to form exposure light pulses with a target width, which are directly input into the second-stage optical splitting array 5 behind.

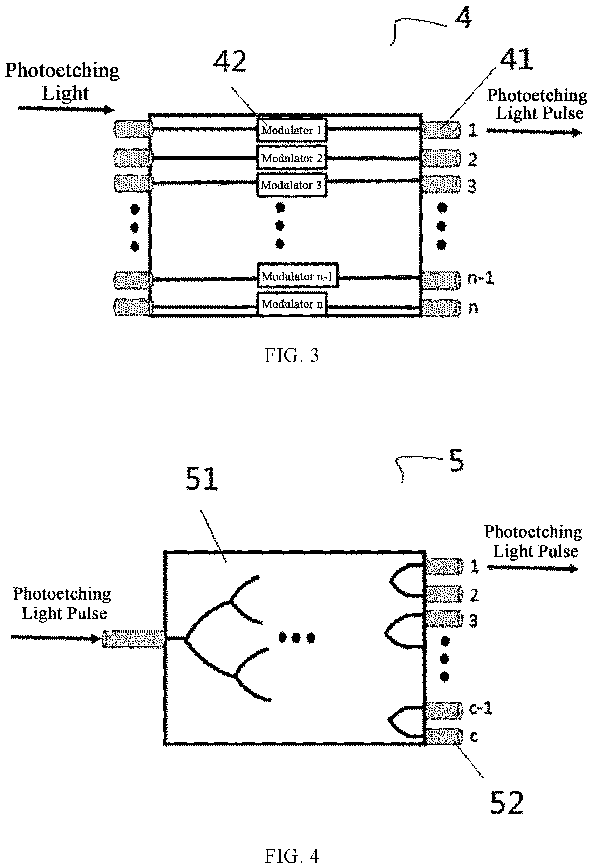

As shown in FIG. 3, the electro-optical modulation array 4 comprises n modulation channels 41 forming an array, which are correspondingly coupled with the first-stage light channels 32, a corresponding modulator 42 is provided in each modulation channel 41, and each modulator 42 corresponds to and controls and modulates the laser output by the corresponding first-stage light channel 32. In each of the modulation channels 41, the corresponding modulator 42 modulates the exposure laser into a corresponding exposure pulse width based on the electro-optical modulation signal 11, but the de-excitation light is not modulated. Wherein, the modulation channels 41 can be optical fibers, each modulation channel 41 and the corresponding modulator 42 can be arranged separately from each other, and the modulation channel 41 can also be an optical waveguide, so that the modulator and the optical waveguide can be integrated.

As shown in FIG. 4, the second-stage light splitting array 5 is provided between the electro-optical modulation array 4 and the optical fiber transmission device 6, and comprises a second optical splitter 51 and c second-stage light channels 52, wherein the second-stage optical splitting array 5 here uniformly distributes the photoetching light pulses and unmodulated de-excitation light output from each of the n modulation channels 41 of the electro-optical modulation array 4 into c second-stage light channels 52, which output coaxial photoetching light pulses and continuous de-excitation laser in the form of an optical fiber coupler, so that the second-stage optical splitting array 5 outputs n*c double beams, and each optical fiber has a corresponding exposure light pulse and de-excitation light, so that the intensities of photoetching light and de-excitation light can be uniformly distributed in the n*c optical fibers respectively. The second optical splitter 52 here can be realized by using separation optical elements, such as a beam splitter, a reflector or the like, or by using an integrated optical waveguide.

The optical fiber transmission device 6 here refers to optical fiber(s) used for transmitting modulated optical signal, which receives pulses with optical intensity output by the second-stage light splitting array 5 after being modulated by the electro-optical modulation array 4. The optical fiber here can be single-mode or multi-mode optical fiber, which can be made of organic optical fiber or quartz optical fiber, and single-mode quartz optical fiber is preferred here. The light pulse signal output by the optical fiber transmission device 6 is used for realizing exposure.

The optical fiber transmission device 6 can be an optical fiber bundle for photoetching, which can directly transmit a light beam for photoetching from a light source to the surface of the photoresist that needs to be exposed for later photoetching. The optical fiber transmission device 6 can be an optical fiber bundle for photoetching which comprises c sub-optical fiber bundles that is same with the c chips to be produced on the wafer in quantity, each sub-optical fiber bundle comprises n optical fibers, and each optical fiber for photoetching can receive at least two Gaussian exposure light pulses 1 and de-excitation light beam with different wavelengths which have undergone spatial optical coupling.

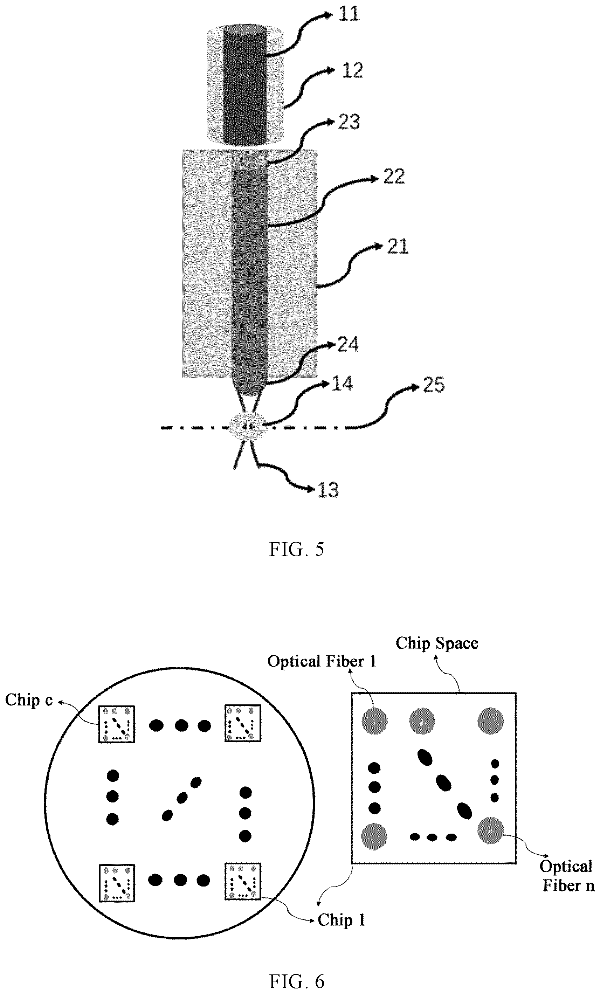

As shown in FIG. 5, the optical fiber for photoetching comprises an optical fiber core 22 for transmitting light beams, and an optical fiber cladding 21 is provided around the outer side of the optical fiber core 22; the optical fiber core 22 and the optical fiber cladding 21 here can be made of any suitable material having a small absorption coefficient for light beams in the wavelength range of 193 nm-2 µm, for example. Wherein, the optical fiber core 22 here can be made of doped quartz material, preferably, the optical fiber core 22 is made of CaF2 or doped CaF2, and the optical fiber cladding 21 can be made of undoped quartz material, preferably, the optical fiber cladding 21 is made of quartz or CaF2 material.

Wherein, in order to ensure the transmission of two types of Gaussian beams, the diameter of the optical fiber core 22 is between 0.5 µm and 10 µm, and the outer diameter of the optical fiber cladding 21 is between 15 µm and 100 µm. Here, the optical fiber core 22 can realize simultaneous single-mode propagation for the wavelength of the exposure Gaussian beam 11 for exposure and the wavelength of the de-excitation Gaussian beam 12, or at least realize single-mode propagation for the exposure Gaussian beam 11. In addition, there is a difference between the optical refractive indexes of the optical fiber cladding 21 and the optical fiber core 22, specifically, the difference between the optical refractive indexes of the optical fiber cladding 21 and the optical fiber core 22 is between 0.01 and 0.2, so as to facilitate the transmission of Gaussian beam in the optical fiber core 22.

Further, a spiral phase structure 23 is provided at the incident end of the optical fiber core 22, and the function of the spiral phase structure 23 is to transform the de-excitation Gaussian beam 12 into a doughnut-shaped de-excitation structured light beam 14 at the wavelength of de-excitation light without affecting the Gaussian exposure light pulses 11, so that the exposure pulses can be transmitted to the surface of the photoresist in the form of Gaussian beam.

The spiral phase structure 23 here can be made by micro-nano fabrication technology; wherein, the spiral phase structure 23 may be in the form of a spiral phase plate. Specifically, spiral phase plates with different etching depths may be provided on the axis of the optical fiber core 22 along the celestial angle direction of the end face of the optical fiber cladding 21, wherein the spiral phase plate may be made by processing technologies such as FIB. Specifically, a plurality of different sectors may be formed at the incident end position of the optical fiber cladding 21, that is, on the end face of the optical fiber core 22 along the axis direction, wherein the material of the optical fiber core 22 in each sector is etched into a different height so as to form a spiral structure. Of course, the spiral phase structure 23 can also be a metasurface structure that meets the requirement of spiral phase and can focus at the exposure wavelength, formed at the incident end position of the optical fiber cladding 21 by processing the end face of the optical fiber core 22. Specifically, several different sectors can be formed on the end face of the optical fiber core 22, and the surface of the optical fiber core 22 in each sector has different two-dimensional metasurface structures. Here, whether in the form of a spiral phase plate or a two-dimensional metasurface structure, it is possible to directly convert the de-excitation Gaussian beam 12, such as laser, into a doughnut-shaped structured light beam 14 without affecting the exposure light pulses, ensuring that the Gaussian exposure pulses 11 can directly reach the surface of the photoresist.

Further, a lens structure 24 is provided outside the exit end of the optical fiber cladding 21. The lens structure 24 may have an arc-shaped convex structure, and a focal plane 25 exits outside the lens structure 24. The lens structure 24 is used to make the Gaussian exposure light pulses 11 form a highly focused beam spot in the focal plane 25 of the lens structure 24 without affecting the doughnut-shaped de-excitation light. The lens structure 24 here can be, for example, a focusing lens for optical fiber exposure; specifically, the lens structure 24 may be an optical fiber lens formed on the end face of the optical fiber core 22 by chemical etching or a metasurface lens formed on the end face of the optical fiber cladding 21 by micro-nano fabrication technology.

Since the optical fiber bundle for photoetching is an aggregation of a plurality of optical fibers for photoetching, when the optical fiber bundle for photoetching comprises a plurality of optical fibers for photoetching, the spiral phase structures 23 in all the optical fibers form an array, and the lens structures 24 in all the optical fibers for photoetching form an array, so that the optical fiber bundle for photoetching formed by a plurality of optical fibers for photoetching can be used for multi-beam photoetching, further improving the exposure rate.

When two Gaussian beams with different wavelengths are coupled into the optical fiber for photoetching through spatial optical coupling, the spiral phase structure 23 located at the end face of the optical fiber core 22 converts the de-excitation Gaussian beam 12 into a doughnut-shaped structured light beam 14, and the doughnut-shaped de-excitation Gaussian beam 12 and the Gaussian exposure light pulses 11 are coaxially transmitted through the optical fiber core 22 to the other end face of the optical fiber core 22. The lens structure 24 located on the other end face causes the Gaussian exposure light pulses 11 to form a focused photoetching beam 13 in the focal plane 25 of the lens structure without affecting the doughnut structure of the de-excitation light. Moreover, optical axis of the doughnut-shaped structured light beam 14 and the focused photoetching light pulses 13 on the focal plane 25 are kept coincident, and the Gaussian beam 13 is always located in the inner circle with the weakest intensity in the doughnut-shaped structured light. In this way, by adjusting the intensity of the de-excitation light, the radius of the inner circle can be effectively reduced, and the photoetching range which the Gaussian exposure pulse inside can realize can be limited to realize super-resolution photoetching.

In this way, when the wafer coated with photoresist is arranged on the focal plane 25, the size of the hollow structure in the doughnut of the structured light beam 14 formed by the de-excitation Gaussian beam 12 can be controlled by adjusting the exposure time and energy for focusing photoetching beam 13 and adjusting the intensity of the de-excitation light beam 14. Specifically, when the intensity of the de-excitation Gaussian beam 12 can ensure an reduction of the effective de-excitation diameter of the doughnut-shaped structure to limit the size that the photoetching beam 13 can be exposed, breaking through the diffraction limit to achieve the effect of super-resolution photoetching.

In a specific embodiment, the photoetching optical fiber of the embodiment of the present disclosure can be made by the following method: firstly, a suitable material with small absorption coefficient for the wavelength range of 193 nm-2 µm, such as SiO2 and CaF2, is selected, and the optical fiber core 22 and the optical fiber cladding 21 are made by doping or other technologies and optical fiber preparation technologies, the photoetching optical fiber can form a single-mode fiber meeting the wavelength range of 193 nm-2 µm, especially this single-mode optical fiber can realize single-mode transmission of the de-excitation Gaussian beam 12, and can transform the de-excitation Gaussian beam 12 into a doughnut-shaped structured light beam 14 with maximum efficiency.

A spiral phase plate is formed on the end face of the optical fiber core 22 located at the incident end of the optical fiber cladding 21 by micro-nano fabrication technology, and the spiral phase plate transforms the Gaussian beam into a doughnut-shaped structured light beam 14 at the wavelength of the de-excitation Gaussian beam 12, so that the Gaussian exposure beam 11, such as ultraviolet light with photoetching wavelength, after passing through the spiral phase plate, still propagates as a Gaussian light spot in the optical fiber core 22 and finally forms a photoetching beam 13. Further, the lens structure 24, such as a fiber lens, is prepared on the end face of the fiber core 22 located at the exit end of the optical fiber cladding 21 by chemical etching, etc. The lens structure 24 can effectively focus the Gaussian photoetching beam on the focal plane 25 without changing the structure of the doughnut-shaped structured light beam 14 on the focal plane 25, so that at least the structured light beam 14 formed by the de-excitation Gaussian beam 12 and the exposure Gaussian beam 11, for example, ultraviolet photoetching light, are used to realize super-resolution photoetching function on the photoresist on the focal plane 15.

The embodiment of the present disclosure can realize coaxial transmission of photoetching light and de-excitation light between the light source and the photoresist surface through optical fiber, which can directly transmit the light energy for exposure and the de-excitation light energy limiting the exposure range from the light source to the photoresist surface through the optical fiber, without lenses and lens groups, and the system is easy to install, occupies small space, and reduces the cost and maintenance cost; the simultaneous and coaxial propagation of at least two beams with different wavelengths is realized by using a single optical fiber, which greatly reduces the technical difficulty of lens group adjustment in dual-beam photoetching technology. In addition, the phase structure of the end face of the optical fiber is used to transform the de-excitation Gaussian light beam into doughnut-shaped structured light, which can realize the super-resolution photoetching of magnitude of 20 nm or even 10 nm by using ordinary ultraviolet light through STED photoetching technology.

As shown in FIG. 6, the optical fiber focusing array 7 here can be a fiber lens, which can be coupled with the optical fiber transmission device 6. The optical fiber focusing array 7 spatially arranges n*c optical fibers in a sub-optical fiber bundle structures corresponding to c chips on a wafer to be processed on a production line, and each sub-optical fiber bundle uniformly arranges n optical fibers in the corresponding chip space in the same order, as shown in FIG. 6, the n optical fibers in each sub-optical fiber bundle form a sub-focal plane for the exposure light pulses and the sub-focal planes of c sub-optical fibers constitute an exposure focal plane.

Here, the electric drive workpiece table 8 comprises a plurality of driving devices to realize the precise positioning and control of the exposure position on the photoetching material in three axial directions XYZ, and the driving devices here can be, for example, a motor unit, wherein the X-axis and the Y-axis are located in the focal plane of the optical fiber focusing array 7 in which light pulses are focused, and the Z axis is in the direction perpendicular to the focal plane.

Further, the positioning and control accuracy of the electric drive workpiece table 8 in the Z-axis direction is on the order of 100 nm-10 µm. Therefore, the motion control in the Z-axis direction can be preferably realized by using a stepping motor or a piezoelectric motor, where the maximum displacement amount of the electric drive workpiece table 8 under control of the motor unit is between 5 mm and 50 mm.

The movement of the electric drive workpiece table 8 in the X-axis and Y-axis directions is controlled by two independent groups of motor units, each group of motor units at least comprises a stepping motor and a piezoelectric motor, and the positioning accuracy of each group of motor units can be realized by, for example, a laser interferometer, for example, by using a positioning signal emitted by the laser interferometer and a driving signal of the piezoelectric motor to form a closed-loop control signal to control the positioning accuracy. In this way, the positioning and control accuracy in the X-axis and Y-axis directions in the focal plane is controlled as between 2 nm and 1 µm, and the motor unit controls the maximum displacement of the electric drive workpiece table 8 under control of the motor unit is 50 mm to 320 mm. Of course, the electric drive workpiece table 8 can also have abilities of rotating in the focal plane and the oblique positioning and control in which normal of the XY plane deviates from the focused light.

Embodiments of the present disclosure can form large-area super-resolution photoetching micro-nano structures on the surface of photoetching materials such as wafers or other materials, thus meeting the research, development and production needs of integrated circuits and other micro-nano systems, for example.

The photoetching machine with optical fiber arrays according to the embodiments of the present disclosure uses, for example, an ultraviolet laser light source as the photoetching light source, transmits the photoetching light to the electro-optical modulation array through a light splitting array to realize high-speed modulation of the light intensity of the photoetching light with the modulation frequency of up to 100 GHz, and further transmits the exposure light pulses to the optical fiber transmission device through a light splitting array to form a plurality of sub-optical fiber bundles parallelly corresponding to multiple chips. A plurality of optical fibers in each sub-optical fiber bundle correspond to parallel processing in the chip, and the exposure range of exposure light pulses can be restricted by using the de-excitation optical fiber in each optical fiber, in combination with the synchronous electric drive workpiece table and electro-optical modulation, so that high-speed and large-area super-resolution photoetching patterns can be achieved with high speed on semiconductor wafers or other research samples coated with photoresist, meeting the requirement of chip production. Specifically, the optical fiber photoetching machine according to the embodiments of the present disclosure realizes photoetching functions through the following solutions.
(1) Photoresist with ideal thickness is coated on the surface of a semiconductor wafer or other photoetching materials, and after the photoresist is cured by baking or other methods, the photoresist material is placed on the electric drive workpiece table 8. The electric drive workpiece table 8 moves and positions in the Z-axis direction through a driving device that controls movement in the Z-axis direction, wherein the photoresist is positioned in the focal plane formed by the optical fiber focusing array 7; the electro-optical modulation array 4 calls the electro-optical modulation pulse width for calibration to complete the photoetching of the exposure point corresponding to each optical fiber; after developing and fixing, for the deviation between the point exposure structure of each optical fiber and the calibration pattern, a database for correcting the photoetching pulse width corresponding to each optical fiber is calculated and stored by the control device 1.
(2) A chip or micro-nano system layout is designed through the design software built in the control device 1, or a design layout obtained through the third-party software is imported into the control device 1 after conversion; wherein, the control device 1 decomposes the design layout of a chip or micro-nano system into multiple layers of pattern depending on the processing technology, and generates photoetching data based on each layer of pattern.

Wherein, the control device 1 obtains photoetching data related to realizing exposure required by photoetching operation based on the design layout, and decomposes the photoetching data into driving device control data and corresponding electro-optical modulation data, wherein the driving device control data at least comprises position information on all exposure positions and non-exposure positions on photoetching materials, such as wafers, that meet the requirements of photoetching process, positioning of the position of the photoetching materials on the electric drive workpiece table 8 corresponding to each position, and movement control data of the driving device; the electro-optical modulation data at least comprises voltage signal data and pulse width data corresponding to each exposure position and non-exposure position.

(3) After the wafer coated with the photoetching material, for example, moves to position of the focal plane of the optical fiber focusing array 7 through the electric drive workpiece table 8, the control device 1 controls the electric drive workpiece table 8 to move in the X-axis and Y-axis directions based on the workpiece table control signal 12, and after the photoetching material is moved to the initial exposure point position, according to the modulation voltage and pulse width signal corresponding to each exposure position in the electro-optical modulation data and thus based on the electro-optical modulation signal 11, obtain matching exposure light pulses by modulation, match the intensity of the exposure light pulses and that of the doughnut-shaped de-excitation light which is adjusted as required, and complete the photoetching at the current exposure position;
The control device 1 continues to control the electric drive workpiece table 8 to move in the focal plane, move the semiconductor wafer coated with the photoetching material, for example, to the next exposure position of the current photoetching, and perform the corresponding electro-optical modulation operation in the electro-optical modulation data.

After the electro-optical modulation signal 11 for the electro-optical modulation array 4 and the workpiece table control signal 12 for the electric drive workpiece table 8, transmitted by the control device 1, sequentially complete the driving of the workpiece table to move and the electro-optical modulation corresponding to each movement to realize the exposure of the exposure positions of each chip, the current photoetching is completed.

(4) After the photoetching materials, such as wafers, that have completed current photoetching exit the optical fiber photoetching machine through the electric drive workpiece table 8, they enter other etching or coating or ion implantation, annealing or other related processes after development and fixation. Finally, all the process steps of the current photoetching operation are completed.

(5) According to the actual situation of the design layout or process line of the chip or micro-nano system, the above steps (1)-(3) are repeated to complete the photoetching process of the chip or micro-nano system.

In the embodiments of the present disclosure, a laser light source in the range of 193 nm to 405 nm is used as the photoetching light, and an electro-optical modulation array is used to perform switch modulation on optical intensity of the photoetching light to obtain exposure light pulses with modulation frequency of up to 100 GHz; further, processing in parallel by forming an array of multiple optical fibers to further improve exposure yield; the doughnut-shaped structured light of 550 nm-1100 nm is used to limit the area of the photoresist that can be exposed by the photoetching light pulses located at the inner circle of its structure; high-speed and large-area high-resolution photoetching is formed on semiconductor wafers or other research samples coated with photoresist by using synchronous electric drive workpiece table and electro-optical modulation. Especially, in the present embodiment, optical fiber arrays are used to realize multi-beam parallel photoetching, which improves the productivity of photoetching machine. Each optical fiber coaxially transmits doughnut-shaped de-excitation light and Gaussian photoetching light pulses to realize super-resolution photoetching. According to the embodiments of the present disclosure, photoetching can be directly realized from the design layout of the chip without a photoetching mask, realizing the digital production of the chip. Embodiments of the present disclosure are suitable for research, development and production of integrated circuit or other similar integrated micro-nano systems.

The above description is only the preferred embodiments of the present disclosure and the explanations of the applied technical principles. It should be understood by those skilled in the art that the disclosure scope involved in the present disclosure is not limited to the technical solution formed by the specific combination of the above technical features, but also covers other technical solutions formed by any combination of the above technical features or their equivalent features without departing from the above disclosure concept. For example, the above features and technical features with similar functions disclosed in the present disclosure, but not limited to, can be replaced with each other to form a technical solution.

Furthermore, although operations are depicted in a particular order, this should not be understood as requiring that these operations be performed in the particular order shown or in a sequential order. Under certain circumstances, multitasking and parallel processing may be beneficial. Likewise, although several specific implementation details are contained in the above discussion, these should not be construed as limiting the scope of the present disclosure. Some features described in the context of individual embodiment can also be combined in a single embodiment. On the contrary, various features described in the context of a single embodiment can also be implemented in multiple embodiments individually or in any suitable sub-combination.

Although the subject matter has been described in language specific to structural features and/or methodological logical acts, it should be understood that the subject matter defined in the appended claims is not necessarily limited to the specific features or actions described above. On the contrary, the specific features and actions described above are only exemplary forms for implementing the claims.

Although a number of embodiments of the present disclosure have been described in detail above, the present disclosure is not limited to these specific embodiments, and those skilled in the art can make various variations and modifications on the basis of the concept of the present disclosure, and these variations and modifications should fall within the scope of protection claimed by the present disclosure.

## Claims

1. A photoetching machine with optical fiber arrays, comprising a control device, an optical fiber transmission device, a light focusing array and an electric drive workpiece table, **characterized in that** further comprising a photoetching light source, a de-excitation light source, a first-stage light splitting array, an electro-optical modulation array and a second-stage light splitting array, wherein the photoetching light source and the de-excitation light source respectively emit an exposure Gaussian beam and a de-excitation Gaussian beam with different wavelengths, the control device is connected to the electro-optical modulation array and the electric drive workpiece table, and is used for controlling the electro-optical modulation array to modulate a laser emitted by the laser light source and controlling the electric drive workpiece table to move based on a design layout.

2. The photoetching machine with optical fiber arrays according to claim 1, **characterized in that** the control device is used for decomposing the design layout into multiple layers of pattern depending on the processing technology, generating photoetching data based on each layer of pattern, and generating electro-optical modulation signal for the electro-optical modulator and workpiece table control signal for the electric drive workpiece table based on the photoetching data.

3. The photoetching machine with optical fiber arrays according to claim 1, **characterized in that** the first-stage light splitting array is provided between the laser light source and the electro-optic modulation array, and comprises a first light splitter and n first-stage light channels, and the first-stage light splitting array is used for uniformly distributing the laser emitted by the laser light source into the n first-stage light channels through the first light splitter, and the n first-stage light channels output photoetching light in a form of an optical fiber coupler.

4. The photoetching machine with optical fiber arrays according to claim 3, **characterized in that** the electro-optical modulation array comprises n modulation channels forming an array, the modulation channels are correspondingly coupled with the first-stage light channels, a corresponding modulator is provided in each modulation channel, and each modulator corresponds to and controls and modulates the photoetching light output from the corresponding first-stage light channel.

5. The photoetching machine with optical fiber arrays according to claim 4, **characterized in that** the second-stage light splitting array is provided between the electro-optical modulation array and the optical fiber transmission device, and comprises a second light splitter and c second-stage light channels, wherein the second-stage light splitting array uniformly distributes the photoetching light pulses output from each of the n modulation channels of the electro-optical modulation array into the c second-stage light channels, and the c second-stage light channels output photoetching light pulses in a form of an optical fiber coupler.

6. The photoetching machine with optical fiber arrays according to claim 1, **characterized in that** the optical fiber transmission device is an optical fiber bundle for photoetching, which is capable of at least receiving an exposure Gaussian beam and a de-excitation Gaussian beam with different wavelengths, and the optical fiber bundle for photoetching comprises c sub-optical fiber bundles, each of which comprises n optical fibers, each of which comprises an optical fiber core for transmitting light beams, an optical fiber cladding is provided around the outer side of the optical fiber core, a spiral phase structure is provided at an incident end of the optical fiber core, and a lens structure is provided at the outer side of an exit end of the optical fiber core.

7. The photoetching machine with optical fiber arrays according to claim 1, **characterized in that** the exposure Gaussian beam is ultraviolet light, and the de-excitation Gaussian beam is a laser beam, wherein during exposure, the de-excitation Gaussian beam is converted into a doughnut-shaped structured light beam, and the exposure Gaussian beam is located in an inner circle with the weakest light intensity of the doughnut-shaped structured light beam.

8. The photoetching machine with optical fiber arrays according to claim 1, **characterized in that** the light focusing array is a fiber lens that is capable of being coupled with the optical fiber transmission device.

9. The photoetching machine with optical fiber arrays according to claim 1, **characterized in that** the electric drive workpiece table comprises a plurality of driving devices to realize the positioning and control of an exposure position on the photoetching material in three axial directions XYZ, wherein the X-axis and the Y-axis are located in the focal plane in which the light focusing array focuses the optical signal, and the Z-axis is along the direction perpendicular to the focal plane.
